# EUROPEAN PATENT SPECIFICATION

(11) **EP 1 875 252 B1**
(45) Date of publication and mention of the grant of the patent: **18.07.2018**
(21) Application number: 06726347.5
(22) Date of filing: 03.03.2006
(51) Int. Cl.: G01R 27/14, G01R 27/18

(54) **METHOD AND APPARATUS FOR MONITORING THE EARTH LOOP IMPEDANCE OF AN ELECTRICAL INSTALLATION**
VERFAHREN UND VORRICHTUNG ZUR ÜBERWACHUNG DER ERDSCHLEIFENIMPEDANZ EINER ELEKTRISCHEN INSTALLATION
PROCEDE ET APPAREIL PERMETTANT DE SURVEILLER L'IMPEDANCE DE BOUCLE DE TERRE D'UNE INSTALLATION ELECTRIQUE

(30) Priority: 03.03.2005 GB 0504352
(43) Date of publication of application: 09.01.2008
(73) Proprietor: Eaton Industries Manufacturing GmbH, 1110 Morges (CH)
(72) Inventor: REEDER, Brian, M., Anglesey, LL59 5NE (GB)
(74) Representative: Eaton IP Group EMEA
(86) International application number: PCT/GB2006/000777
(87) International publication number: WO 2006/092621

(56) References cited:
- EP-A- 0 295 800
- EP-A- 1 306 682
- WO-A-03/036315
- GB-A- 2 343 005
- US-A- 4 368 498

## Description

This invention relates to a method and apparatus for monitoring the earth loop impedance of an electrical installation that is protected by a circuit protection device, such as a residual current device. Said method and apparatus enabling an earth loop impedance test to be performed on an electrical installation without tripping the circuit protection device.

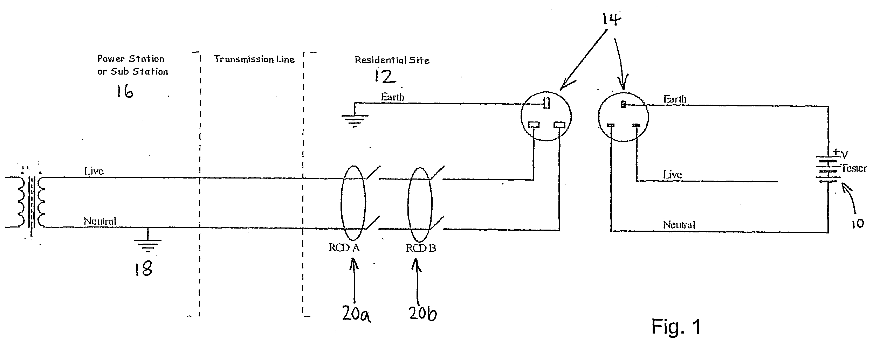

Domestic systems are required to have their earth loop impedance tested as such is essential in verifying the safety of electrical installations. Typically, a test setup is used similar to that shown in Figure 1, where a test box 10 supplying a test voltage is applied at a customer's premises 12, usually connected directly to a socket outlet 14. The test voltage generates a current which flows via the neutral lead to the power station or local sub station 16 and then returns via the earth connection 18 back to the premises 12. By measuring the current flowing, the earth loop impedance can be determined.

However, a problem exists when circuit protection devices such as earth leakage circuit breakers (ELCBs) or residual current devices (RCDs) 20a, 20b are fitted in the customer's premises. Generally speaking, an RCD consists of an toroid having the supply phase and neutral passing therethrough, which acts as the primary winding of a current transformer; a secondary winding around the toroid is connected to a trip mechanism. Under normal conditions, the phase and neutral currents are equal and opposite so that no flux is induced in the toroid and hence no current flows in the secondary winding. If a fault condition occurs and current flows through the earth path back to the energy source, the phase and neutral currents will no longer be balanced and a flux will be induced in the toroid, which will activate the trip mechanism and disconnect the electrical supply.

Unfortunately, as RCDs 20a, 20b are present to detect leakage current to earth, the connection of an earth loop impedance tester to check the integrity of the earth loop impedance trips the RCD whenever a test current is passed. In order to address this, loop impedance testers 10 have been developed using very low test currents, such that any RCDs present do not trip, but these, as a result, are not particularly accurate. Current practice is to short circuit any RCDs present 20a, 20b before performing a test. This is time-consuming for the person performing the test and dangerous if the short circuits are forgotten and left in place afterwards.

Other examples of prior art arrangements have been disclosed in GB 2 239 530 and EP 0 295 800 which describe methods and apparatus for temporarily desensitising the operation of the RCD by injecting a DC current or a very low frequency AC current into the sensing circuit of the RCD to saturate the toroid core, and so that a loop impedance test can then be made. EP 0 278 174 describes an earth monitoring apparatus whereby the earth loop impedance is measured by injecting a high frequency test signal into the earth conductor, and measuring the resultant current flowing through the earth conductor, so as to provide a measurement of the earth impedance. The integral earth leakage protection is insensitive to this high frequency test signal and therefore does not trip.

These approaches however suffer from a number of disadvantages in that the DC test signal or the high frequency AC test signal shift the operating point of the toroid to a point on its B-H curve where it can be insensitive to a genuine earth fault current. Hence, the sensitivity of the RCD will be reduced which, of course, could be extremely dangerous should a fault condition occur shortly after an earth loop impedance test has been performed.

These approaches also suffer from poor measurement accuracy, as the measurement frequency is not representative of the normal operating frequency of 50Hz or 60Hz.

WO 03/036315 discloses a loop impedance meter.

It is the object of the present invention to provide a method and apparatus for monitoring the earth loop impedance of an electrical installation that is protected by a circuit protection device, such as a residual current device. Said method and apparatus enabling an earth loop impedance test to be performed on an electrical installation without tripping the circuit protection device and to maintain the sensitivity of the device after an earth loop impedance test has been performed. It is a further object of the present invention to provide a method and apparatus which automatically signals to any circuit protection devices present in the electrical installation that an earth loop impedance test is about to be performed. It is a further object of the present invention to provide a circuit protection device, such as a residual current device, which can detect the earth loop impedance test signal and not trip for a predetermined interval. After the predetermined interval, the circuit protection device reverts to its normal operation.

According to the present invention there is provided:
a method of temporarily disabling the operation of a circuit protection device having an electrical installation connected thereto and determining the earth loop impedance of said electrical installation;
an apparatus for determining the earth loop impedance of an electrical installation that is protected by a remote circuit protection device; and
a circuit protection device for detecting a residual current on an electrical installation, as claimed.

Preferably, said circuit protection device is a residual current device. In use, said relay means further comprises a trip coil controlling main contacts in the phase and neutral of said electrical supply. Said relay means further comprising overload and earth fault elements.

Further preferably, said circuit protection device is a digital residual current device, implemented using a microprocessor or digital signal processor. In use, the output of said detection means is sampled and converted from analogue to digital for processing by said processing means.

In a preferred embodiment, the signal sequence may be any form that is producible by said source and detectable by said circuit protection device. The signal sequence may be unique, such that said circuit protection device is disabled only when an earth loop impedance test is about to be performed. In use, said second part of said sequence, which is used to determine the earth loop impedance of the electrical installation, has a normal mains frequency of 50Hz or 60Hz.

Also according to the present invention there is provided an apparatus for determining the earth loop impedance of an electrical installation that is protected by a remote circuit protection device, comprising:
a source for injecting a signal sequence into a conductor of said electrical installation under test, said signal sequence comprising a first part of said sequence to disable operation of said remote circuit protection device and a second part of said sequence to monitor the earth loop impedance of said electrical installation; and
measuring means for measuring the current flowing in said second part of said sequence to determine said earth loop impedance of said electrical installation.

Further according to the present invention there is provided a circuit protection device for detecting a residual current on an electrical installation, comprising:
detection means for sensing said residual current on said electrical installation, said residual current also comprising a signal sequence generated by a remote source connected to said electrical installation, said signal sequence comprising a first part of said sequence to disable operation of said circuit protection device and a second part of said sequence which, in use, determines the earth loop impedance of said electrical installation by said remote source;
processing means, connected to said detection means, for processing if said signal sequence comprises said first part of said sequence and disabling operation of said circuit protection device for a predetermined period of time; and
relay means, operative from said processing means, for disconnecting the electrical supply to said electrical installation if said residual current exceeds a predetermined fault condition.

Preferably, said circuit protection device is a residual current device. In use, said relay means further comprises a trip coil controlling main contacts in the phase and neutral of said electrical supply. Said relay means further comprising overload and earth fault elements.

Further preferably, said circuit protection device is a digital residual current device, implemented using a microprocessor or digital signal processor. In use, the output of said detection means is sampled and converted from analogue to digital for processing by said processing means.

In a preferred embodiment, the signal sequence may be any form that is producible by said source and detectable by said circuit protection device. The signal sequence may be unique, such that said circuit protection device is disabled only when an earth loop impedance test is about to be performed. In use, said second part of said sequence, which is used to determine the earth loop impedance of the electrical installation, has a normal mains frequency of 50Hz or 60Hz.

In a further embodiment, the source for injecting said signal sequence into a conductor of said electrical installation under test may be implemented using a first source for injecting said first part of said sequence to disable operation of said remote circuit protection device and a second source for injecting said second part of said sequence to monitor the earth loop impedance of said electrical installation. In this embodiment, said first source may be located in a remote ancillary unit situated between said apparatus and said remote circuit protection device.

In use, said detection means comprises a toroid having a supply phase and neutral passing therethrough. The frequency response of said toroid means that the amplitude of the first part of said sequence may be higher for higher signalling frequencies. A lower signalling frequency may be easier to detect.

Preferably, the signalling sequence is within the bandwidth of the RCD detection system (i.e. below approximately 2kHz assuming a digital RCD with a 4kHz sampling frequency). In use, the frequency of said first part of said sequence may be widely separated from said second part of said sequence to allow ease of discrimination in the presence of standing residual currents.

As it is possible for harmonics of the electrical supply to be present in residual currents, discrimination between the first and second parts of the signalling sequence is easier if the said first part of said sequence was also not a harmonic of the mains frequency. All practical residual currents have higher fundamental amplitude than harmonic amplitude, so the presence of a harmonic of the mains frequency with the fundamental would itself provide discrimination.

In use, there is a possibility of any signalling frequency being generated by other appliances connected to the mains supply. As such, the apparatus for monitoring the earth loop impedance further comprises some form of signal modulation and coding.

Preferably, the magnitude of the signal sequence current has to be set to a level sufficient to ensure detection by connected RCDs. Given the unknown earth loop impedance, the apparatus for monitoring the earth loop impedance further comprises some form of feedback control system to provide a signal current source.

In use, the amplitude of said first part of the signal sequence may be set at a level below the minimum trip level of the circuit protection device, or by applying a larger second part of the signal current for a period shorter than the trip detection time, or by preventing the second part of the signal sequence being included in the earth loop impedance test.

It is believed that a method and apparatus for monitoring the earth loop impedance of an electrical installation that is protected by a circuit protection device in accordance with the present invention at least addresses the problems outlined above. The advantages of the present invention are that said method and apparatus enable an earth loop impedance test to be performed on an electrical installation without tripping the circuit protection device and thus maintain the sensitivity of the device after an earth loop impedance test has been performed. Advantageously, the present invention provides a method and apparatus which automatically signals to any circuit protection devices present in the electrical installation that an earth loop impedance test is about to be performed. Furthermore, the present invention provides a circuit protection device, such as a residual current device, which can detect the earth loop impedance test signal and not trip for a predetermined interval. After the predetermined interval, the circuit protection device reverts to its normal operation.

A specific non-limiting embodiment of the invention will now be described by way of example and with reference to the accompanying drawings, in which:
Figure 1 is a schematic diagram illustrating the principle of a known earth loop impedance tester connected to an electrical installation which is protected by residual current devices;
Figure 2 illustrates schematically how the present invention is implemented;
Figure 3 shows a schematic diagram of the general arrangement of the circuit protection device according to present invention; and
Figure 4 shows one example of a signalling sequence I_{signal} generated by the earth loop impedance tester to disable operation of the circuit protection device.

The present invention comprises a method and apparatus for monitoring the earth loop impedance of an electrical installation that is protected by a circuit protection device, such as a residual current device. Such an arrangement is capable of carrying out a test of the earth loop impedance of an electrical installation protected by at least one residual current device, as exemplified, for example, in Figure 1.

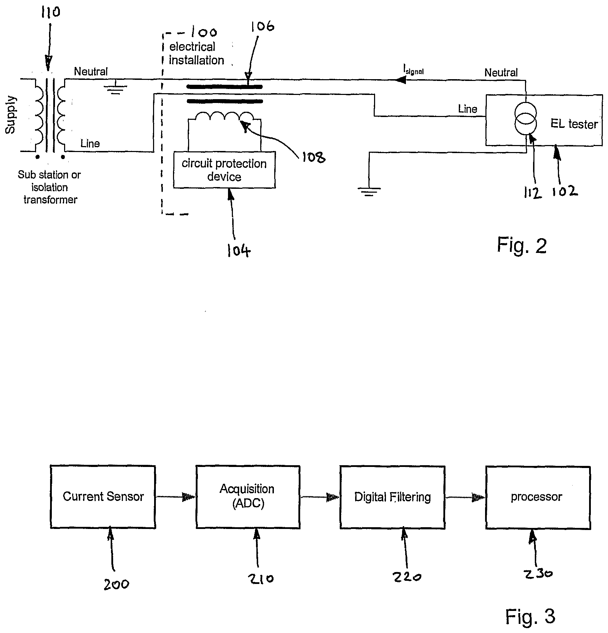

Figure 2 illustrates a preferred embodiment of the present invention that enables an earth loop impedance test to be performed on an electrical installation 100 without tripping the circuit protection device, and which maintains the sensitivity of the device after an earth loop impedance test has been performed. In use, an apparatus for determining the earth loop impedance of an electrical installation 100, such as an earth loop impedance tester 102, is connected to the electrical installation 100 under test, usually via a socket outlet (not shown). The electrical installation 100 under test is protected by at least one circuit protection device 104.

In use, the present invention is achieved using an earth loop impedance tester 102 that automatically signals to any circuit protection devices 104 present in the electrical installation 100 that an earth loop impedance test is about to be performed. The circuit protection device 104 can detect the earth loop impedance tester's signal sequence I_{signal} which comprises a first part of the sequence to disable operation of the circuit protection device 104 for a predetermined interval and a second part of the sequence to monitor the earth loop impedance of said electrical installation 100. After this predetermined interval, the circuit protection device 104 reverts back to its normal operation.

In a further aspect of the invention, it is envisaged that an ancillary unit (not shown) is placed between the earth loop impedance tester 102 and the circuit protection device 104. In use, the ancillary unit includes a transmit button which, when depressed by an operator, sends the first part of the signal sequence to disable operation of the circuit protection device 104 for a predetermined interval. The operator then transmits the second part of the signal sequence using the earth loop impedance tester 102. Co-ordination between the earth loop impedance tester 102 and the ancillary unit to transmit the first and second parts of the signal sequence is either achieved manually or by a communications bus. The ancillary unit can be either powered from the line supply 100 or by a local power source, such as, a battery.

The circuit protection device 104 shown in Figure 2 is implemented using a residual current device which comprises a toroid 106 having the supply phase and neutral passing therethrough, which acts as the primary winding of a current transformer; a secondary winding 108 around the toroid 106 is connected to a trip mechanism (not shown). Upstream from the residual current device is an isolation transformer 110, typically found in a sub station. In use, the residual current device continuously monitors both the current flowing into and out of the electrical installation 100; any difference in the current flow is detected and processed by the residual current device.

The earth loop impedance tester 102 includes a current source 112 arranged so that it is connected between neutral and earth conductors. On performing an earth loop impedance test on the electrical installation 100, a signalling current or sequence I_{signal} is injected down the neutral conductor and returns via the earth connection at the sub station 110. The residual current device senses the injected current I_{signal} as an imbalance between the phase conductors and processes the signal. To ensure that the signalling current I_{signal} does not trip the residual current device, the signalling current I_{signal} comprises a first part of the sequence which is detectable by the residual current device to disable its operation for a predetermined period of time, and a second part of sequence which, in use, determines the earth loop impedance of the electrical installation under test. After the predetermined interval, the residual current device reverts back to its normal operation.

The signal sequence I_{signal} can be any form that is producible by the earth loop impedance tester 102 and detectable by the circuit protection device 104. The signal sequence I_{signal} may be unique, such that the circuit protection device 104 is disabled only when an earth loop impedance test is about to be performed. The particular signal sequence and frequency I_{signal} used to communicate between the earth loop impedance tester 102 and the residual current device can take a number of forms.

The skilled person will appreciate that the amplitude of the first part of the signal sequence I_{signal} can be set at a level below the minimum trip level of the circuit protection device, or by applying a larger second part of the signalling current I_{signal} for a period shorter than the trip detection time, or by applying a signalling current I_{signal} having a unique signalling frequency widely separated from the normal mains frequency to allow discrimination in the presence of, say, standing residual currents on the electrical installation 100.

In one embodiment, a test current I_{signal} below 10mA is used. However, in some circumstances where high current devices (e.g. 500mA RCDs) are utilised, the residual current device may not be sensitive enough to detect the signalling current I_{signal}. For example: a 500mA RCD, allowing for a crest factor of 5 and using a 10-bit converter, gives a resolution of 5mA, so the signalling current I_{signal} would only be twice the resolution and may be hidden within the converter noise and hence undetectable.

In order to address this, a signalling sequence I_{signal} having a current of up to around 50mA may be utilised, providing that it is applied for less than say 20ms (assuming that half of the minimum trip time is used to determine if the device should trip). Code sequences would then have to span several mains cycles so that the overall RMS signal level is less than the trip threshold.

In another embodiment, a notch filter is included in the RCD measurement path, centred around the signalling frequency I_{signal}. This would prevent modified residual current devices tripping on detection of the signalling current I_{signal} and hence allow much larger signalling amplitudes, which would be easily detectable by the whole range of devices.

In a further embodiment, a signalling current I_{signal} of around 1kHz, 50mA, 100% amplitude modulated, with a specific on/off sequence spread over several mains cycles can be utilised. This could be detected within existing RCDs using a simple filter and tone decoder circuit. However, with a digital RCD, the signal presence could be determined by analysis of the residual current sampled data stream using standard data processing techniques, either pattern matching or fast Fourier transform (FFT) analysis.

The amplitude of the signalling pulse I_{signal} is dependent on the construction of the electrical installation 100. Since the installation 100 is protected by a residual current device, ground fault interrupter or earth current monitor, then it is necessary to ensure the maximum amplitude of the signalling pulse I_{signal} is below the threshold of the protection device 104. For example, where IEC 61008, 61009 or 60947 type devices are used, the maximum signalling amplitude I_{signal} should be around half the rated threshold of the device to ensure that the signalling current I_{signal} does not trip the residual current device.

The skilled person will also appreciate that the signalling sequence I_{signal} could be modulated in a number of different ways in order to convey information to the circuit protection device 104; typical modulation schemes include: time, frequency, missing pulse and amplitude modulation.

Figure 3 shows the schematic arrangement of a circuit protection device 104, such as a residual current device, for detecting residual current on the electrical installation 100 in accordance with the present invention. The device includes a current sensor 200, which could be the secondary winding 108 around toroid 106 in Figure 2, or a solid state transducer. The output of the current sensor 200 senses the current imbalance between the phase and neutral on the electrical installation 100 is then taken to an acquisition stage 210 in which this analogue signal is converted to a digital signal which is subsequently filtered 220. To limit the bandwidth and remove any spurious signals, a processor 230 looks for the transmitted signals from the filtered data stream 220. In use, the processor 230 can either be hardware or software-based and any number of detection algorithms could be used. In one example, a correlation algorithm is used to determine the statistic probability of a signalling current I_{signal} being present.

Although not shown in Figure 3, the output of the processor 230 also controls relay means for disconnecting the electrical supply to the electrical installation 100, if the detected residual current exceeds a predetermined fault condition.

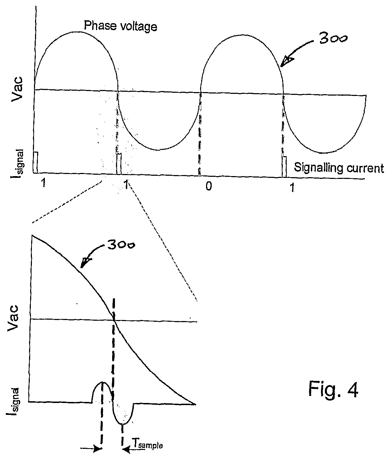

Further detail of one modulation scheme that can utilised in the present invention is depicted in Figure 4. Figure 4 shows the phase voltage 300 on the electrical installation under test together with the discrete signalling sequence I_{signal} generated by the earth loop impedance tester 102, as shown in Figure 2.

In use, the signalling current I_{signal} is phase locked to the line voltage 300 and applied at the zero cross of the phase voltage. The skilled person will appreciate that whilst it is possible to inject the signalling current I_{signal} at any time during the phase voltage cycle, indeed in terms of detecting the signalling current I_{signal} it may be better to inject the signalling current I_{signal} at the peek of the voltage wave, however the necessary processing required to detect the signalling pulse I_{signal} is less demanding at the zero cross.

As shown in Figure 4, the signalling pulse I_{signal} itself is in the form of a sine wave with positive and negative half cycles of equal periods and equal amplitudes. The transition between positive cycles and negative cycles must coincide with the zero cross of the voltage waveform 300. The maximum tolerance for the transition point is ± half the sampling period Tₛₐₘₚₗₑ of the circuit protection device 104. In practice, this tolerance may be increased by using multiple sampling points during both half cycles of the current signal I_{signal}.

In this embodiment, missing pulse modulation is used to transmit binary data to the circuit protection device 104. This data could be an addressing, configuration, control or any other form of data. As the signalling current I_{signal} is unidirectional, there is no possibility to send an acknowledgment from the circuit protection device 104 to the earth loop impedance tester 102, so some form of error detection may be required in order for the circuit protection device 104 to determine the validity of the transmitted data. It is also be advantageous to transmit the signalling sequence I_{signal} a number of times to ensure the message is received correctly by the circuit protection device.

Various alterations and modifications may be made to the present invention without the departing from the scope of the invention as defined by the claims. For example, although particular embodiments refer to implementing the present invention on a domestic consumer's electrical installation, this is no way intended to be limiting as, in use, the present invention could be incorporated into larger installations, both single and multi-phase.

## Claims

1. A method of temporarily disabling the operation of a circuit protection device (104) having an electrical installation (100) connected thereto and determining the earth loop impedance of the electrical installation (100), comprising:
injecting a signal sequence into a conductor of the electrical installation (100) under test from a source providing the signal sequence, the signal sequence comprising a first part to disable operation of the circuit protection device (104) for a predetermined period of time; and a second part to monitor the earth loop impedance of the electrical installation (100);
receiving the signal sequence from the source;
verifying if the signal sequence comprises the first part of the sequence and disabling operation of the circuit protection device (104) for a predetermined period of time; and
measuring the current flowing due to the second part to determine the earth loop impedance of the electrical installation (100).

2. The method according to claim 1, wherein the circuit protection device (104) is a residual current device.

3. The method according to claim 2, wherein the residual current device is a digital residual current device implemented using a microprocessor or digital signal processor.

4. The method according to any preceding claim, wherein said second part of said sequence has a normal mains frequency of 50Hz or 60Hz.

5. The method according to any preceding claim, wherein the frequency of the first part of the sequence is widely separated from the second part of the sequence to allow ease of discrimination.

6. The method according to any preceding claim, wherein the first part of the sequence is not a harmonic of the mains frequency.

7. The method according to any preceding claim, wherein the amplitude of the first part is set at a level below a minimum trip level of the circuit protection device.

8. The method according to any preceding claim, further comprising applying a larger amplitude second part of the sequence for a period shorter than a trip detection time.

9. The method according to any preceding claim, wherein after disabling operation of the circuit protection device (104) for a predetermined period of time, the residual current device reverts back to its normal operation.

10. The method according to any preceding claim, wherein the first part spans several mains cycles, such that an overall RMS signal level is less than the trip threshold of the circuit protection device.

11. The method according to any preceding claim, wherein the signal sequence is modulated to disable operation of the circuit protection device (104).

12. The method according to claim 11, wherein the modulation includes time, frequency, missing pulse or amplitude modulation.

13. The method according to claims 11 or 12, wherein the first part is phase locked to the phase voltage of the electrical installation (100) and applied at the zero cross of the phase voltage.

14. The method according to claim 13, wherein the first part of the sequence is transmitted a number of times to ensure the signal sequence is received correctly by the circuit protection device (104).

15. An apparatus for determining the earth loop impedance of an electrical installation (100) that is protected by a remote circuit protection device (104), comprising:
a source for injecting a signal sequence into a conductor of the electrical installation (100) under test, the signal sequence comprising a first part to disable operation of the remote circuit protection device (104) for a predetermined period of time and a second part having a normal mains frequency of 50Hz or 60Hz to monitor the earth loop impedance of the electrical installation (100); and
measuring means for measuring the current flowing due to the second part to determine the earth loop impedance of the electrical installation (100).

16. The apparatus according to claim 15, wherein the source for injecting a signal sequence into a conductor of the electrical installation (100) under test comprises:
a first source for injecting the first part of the sequence to disable operation of the remote circuit protection device (104); and
a second source for injecting the second part of the sequence to monitor the earth loop impedance of the electrical installation (100).

17. The apparatus according to claim 16, wherein the first source is located in a remote ancillary unit situated between the apparatus and the remote circuit protection device (104).

18. The apparatus according to claim 15, 16 or 17 wherein the signal sequence is any form that is producible by the source and detectable by the circuit protection device (104).

19. The apparatus according to claims 15 or 18, wherein the signal sequence is unique, such that the circuit protection device (104) is disabled only when an earth loop impedance test is about to be performed.

20. The apparatus according to any preceding claim, wherein said second part of said sequence has a normal mains frequency of 50Hz or 60Hz.

21. A circuit protection device (104) for detecting a residual current on an electrical installation (100), comprising:
detection means for sensing the residual current on the electrical installation (100), the residual current also comprising a signal sequence generated by a remote source connected to the electrical installation (100), the signal sequence comprising a first part to disable operation of the circuit protection device (104) for a predetermined period of time and a second part which, in use, determines the earth loop impedance of the electrical installation (100) by the remote source;
processing means, connected to the detection means, for processing if the signal sequence comprises the first part of the sequence and disabling operation of the circuit protection device (104) for a predetermined period of time; and
relay means, operative from the processing means, for disconnecting the electrical supply to the electrical installation (100) if the residual current exceeds a predetermined fault condition.

22. The circuit protection device (104) according to claim 21, wherein the circuit protection device (104) is a residual current device.

23. The circuit protection device (104) according to claim 22, wherein the residual current device is a digital residual current device implemented using a microprocessor or digital signal processor.

24. The circuit protection device (104) according to claim 22, wherein the detection means further comprises a toroid having the supply phase and neutral passing therethrough which acts as the primary winding of a current transformer and a secondary winding around the toroid detects the residual current on the electrical installation (100).

25. The circuit protection device (104) according to claim 24, wherein the output of the secondary winding is converted to a digital signal and subsequently filtered for processing by the processing means.

26. The circuit protection device (104) according to of claims 21to 25, wherein the signal sequence generated by the remote source is within the bandwidth of the detection means.

27. The circuit protection device (104) according to any of claims 21 to 26, wherein after disabling operation of the circuit protection device (104) for a predetermined period of time, the residual current device reverts back to its normal operation.

## Patentansprüche

1. Verfahren zur vorübergehenden Deaktivierung der Funktion einer Schaltungsschutzvorrichtung (104) mit einer elektrischen Installation (100), welche damit verbunden ist, und zur Bestimmung der Erdschleifenimpedanz der elektrischen Installation (100), umfassend:
Einspeisen einer Signalabfolge in einen Leiter der elektrischen Installation (100), welche einem Test unterzogen wird, aus einer Quelle, welche die Signalabfolge bereitstellt, wobei die Signalabfolge einen ersten Teil zur Deaktivierung der Funktion der Schaltungsschutzvorrichtung (104) für eine vorbestimmte Zeitspanne; und einen zweiten Teil zur Überwachung der Erdschleifenimpedanz der elektrischen Installation (100) umfasst;
Empfangen der Signalabfolge aus der Quelle;
Überprüfen, ob die Signalabfolge den ersten Teil der Abfolge umfasst und Deaktivieren der Funktion der Schaltungsschutzvorrichtung (104) für eine vorbestimmte Zeitspanne; und
Messen des Stroms, welcher aufgrund des zweiten Teils fließt, um die Erdschleifenimpedanz der elektrischen Installation (100) zu bestimmen.

2. Verfahren nach Anspruch 1, wobei die Schaltungsschutzvorrichtung (104) ein Fehlerstromschutzschalter ist

3. Verfahren nach Anspruch 2, wobei der Fehlerstromschutzschalter ein digitaler Fehlerstromschutzschalter ist, welcher unter Verwendung eines Mikroprozessors oder digitalen Signalprozessors implementiert ist.

4. Verfahren nach einem der vorstehenden Ansprüche, wobei der zweite Teil der Abfolge eine normale Netzfrequenz von 50 Hz oder 60 Hz aufweist.

5. Verfahren nach einem der vorstehenden Ansprüche, wobei die Frequenz des ersten Teils der Abfolge weit von dem zweiten Teil der Abfolge entfernt ist, um eine einfache Unterscheidung zu ermöglichen.

6. Verfahren nach einem der vorstehenden Ansprüche, wobei der erste Teil der Abfolge keine Harmonische der Netzfrequenz ist.

7. Verfahren nach einem der vorstehenden Ansprüche, wobei die Amplitude des ersten Teils auf einen Pegel unterhalb eines minimalen Ansprechwerts der Schaltungsschutzvorrichtung festgelegt ist.

8. Verfahren nach einem der vorstehenden Ansprüche, weiter das Anlegen eines zweiten Teils der Abfolge mit größerer Amplitude für eine Zeitspanne umfassend, welche kürzer ist, als eine Ansprecherkennungszeit.

9. Verfahren nach einem der vorstehenden Ansprüche, wobei nach Deaktivierung der Funktion der Schaltungsschutzvorrichtung (104) für eine vorbestimmte Zeitspanne der Fehlerstromschutzschalter zu seinem normalen Betrieb zurückkehrt.

10. Verfahren nach einem der vorstehenden Ansprüche, wobei der erste Teil sich über mehrere Netzzyklen erstreckt, sodass ein quadratischer Gesamtmittelwert des Signalpegels kleiner ist als die Ansprechschwelle der Schaltungsschutzvorrichtung.

11. Verfahren nach einem der vorstehenden Ansprüche, wobei die Signalabfolge moduliert wird, um die Funktion der Schaltungsschutzvorrichtung (104) zu deaktivieren.

12. Verfahren nach Anspruch 11, wobei die Modulation Zeit-, Frequenz-, Fehlimpuls- oder Amplitudenmodulation beinhaltet.

13. Verfahren nach Anspruch 11 oder 12, wobei der erste Teil phasenstarr zur Phasenspannung der elektrischen Installation (100) ist und am Nulldurchgang der Phasenspannung angewendet wird.

14. Verfahren nach Anspruch 13, wobei der erste Teil der Abfolge mehrere Male übertragen wird, um zu gewährleisten, dass die Signalabfolge korrekt von der Schaltungsschutzvorrichtung (104) empfangen wird.

15. Vorrichtung zum Bestimmen der Erdschleifenimpedanz einer elektrischen Installation (100), welche mittels einer entfernten Schaltungsschutzvorrichtung (104) geschützt wird, umfassend:
eine Quelle zum Einspeisen einer Signalabfolge in einen Leiter der elektrischen Installation (100), welche einem Test unterzogen wird, wobei die Signalabfolge einen ersten Teil zur Deaktivierung der Funktion der entfernten Schaltungsschutzvorrichtung (104) für eine vorbestimmte Zeitspanne und einen zweiten Teil mit einer normalen Netzfrequenz von 50 Hz oder 60 Hz zur Überwachung der Erdschleifenimpedanz der elektrischen Installation (100) umfasst; und
Messeinrichtungen zum Messen des Stroms, welcher aufgrund des zweiten Teils fließt, um die Erdschleifenimpedanz der elektrischen Installation (100) zu bestimmen.

16. Vorrichtung nach Anspruch 15, wobei die Quelle zum Einspeisen einer Signalabfolge in einen Leiter der elektrischen Installation (100), welche einem Test unterzogen wird, umfasst:
eine erste Quelle zum Einspeisen des ersten Teils der Abfolge zur Deaktivierung der Funktion der entfernten Schaltungsschutzvorrichtung (104); und
eine zweite Quelle zum Einspeisen des zweiten Teils der Abfolge zum Überwachen der Erdschleifenimpedanz der elektrischen Installation (100).

17. Vorrichtung nach Anspruch 16, wobei die erste Quelle sich in einer entfernten Zusatzeinheit befindet, welche zwischen der Vorrichtung und der entfernten Schaltungsschutzvorrichtung (104) gelegen ist.

18. Vorrichtung nach Anspruch 15, 16 oder 17, wobei die Signalabfolge eine beliebige Form aufweist, welche von der Quelle erzeugbar und von der Schaltungsschutzvorrichtung (104) erkennbar ist.

19. Vorrichtung nach Anspruch 15 oder 18, wobei die Signalabfolge eindeutig ist, sodass die Schaltungsschutzvorrichtung (104) nur deaktiviert wird, wenn die Ausführung eines Erdschleifenimpedanztests unmittelbar bevorsteht.

20. Vorrichtung nach einem der vorstehenden Ansprüche, wobei der zweite Teil der Abfolge eine normale Netzfrequenz von 50 Hz oder 60 Hz aufweist.

21. Schaltungsschutzvorrichtung (104) zum Erkennen eines Fehlerstroms in einer elektrischen Installation (100) umfassend:
Erfassungseinrichtung zum Wahrnehmen des Fehlerstroms in der elektrischen Installation (100), wobei der Fehlerstrom auch eine Signalabfolge umfasst, welche mittels einer mit der elektrischen Installation (100) verbundenen entfernten Quelle erzeugt wird, wobei die Signalabfolge einen ersten Teil zum Deaktivieren der Funktion der Schaltungsschutzvorrichtung (104) für eine vorbestimmte Zeitspanne und einen zweiten Teil umfasst, welcher, bei Verwendung, die Erdschleifenimpedanz der elektrischen Installation (100) mittels der entfernten Quelle bestimmt;
Verarbeitungseinrichtung, welche mit der Erfassungseinrichtung verbunden ist, zum Verarbeiten, ob die Signalabfolge den ersten Teil der Abfolge umfasst und Deaktivieren der Funktion der Schaltungsschutzvorrichtung (104) für eine vorbestimmte Zeitspanne; und
Relaiseinrichtung, welche von der Verarbeitungseinrichtung betreibbar ist, zum Trennen der elektrischen Versorgung der elektrischen Installation (100), wenn der Fehlerstrom eine vorbestimmte Fehlerbedingung übersteigt.

22. Schaltungsschutzvorrichtung (104) nach Anspruch 21, wobei die Schaltungsschutzvorrichtung (104) ein Fehlerstromschutzschalter ist

23. Schaltungsschutzvorrichtung (104) nach Anspruch 22, wobei der Fehlerstromschutzschalter ein digitaler Fehlerstromschutzschalter ist, welcher unter Verwendung eines Mikroprozessors oder digitalen Signalprozessors implementiert ist.

24. Schaltungsschutzvorrichtung (104) nach Anspruch 22, wobei die Erfassungseinrichtung weiter eine Ringspule umfasst, durch welche Phase und Nullleiter der Versorgung hindurch geleitet werden, welche als primäre Wicklung eines Stromtransformators agiert, und eine sekundäre Wicklung rund um die Ringspule den Fehlerstrom in der elektrischen Installation (100) erkennt.

25. Schaltungsschutzvorrichtung (104) nach Anspruch 24, wobei die Ausgabe der sekundären Wicklung in ein digitales Signal konvertiert und anschließend für eine Verarbeitung mittels der Verarbeitungseinrichtung gefiltert wird.

26. Schaltungsschutzvorrichtung (104) nach den Ansprüchen 21 bis 25, wobei die mittels der entfernten Quelle erzeugte Signalabfolge sich innerhalb der Bandbreite der Erfassungseinrichtung befindet.

27. Schaltungsschutzvorrichtung (104) nach einem der Ansprüche 21 bis 26, wobei nach Deaktivierung der Funktion der Schaltungsschutzvorrichtung (104) für eine vorbestimmte Zeitspanne der Fehlerstromschutzschalter zu seinem normalen Betrieb zurückkehrt.

## Revendications

1. Procédé permettant de désactiver provisoirement le fonctionnement d'un dispositif de protection de circuit (104) auquel est connectée une installation électrique (100) et de déterminer l'impédance de boucle de terre de l'installation électrique (100), comprenant :
l'injection d'une séquence de signaux dans un conducteur de l'installation électrique (100) à tester depuis une source fournissant la séquence de signaux, la séquence de signaux comprenant une première partie pour désactiver le fonctionnement du dispositif de protection de circuit (104) pendant une durée prédéterminée ; et une seconde partie pour surveiller l'impédance de boucle de terre de l'installation électrique (100) ;
la réception de la séquence de signaux de la source ;
le fait de vérifier si la séquence de signaux comprend la première partie de la séquence et la désactivation du fonctionnement du dispositif de protection de circuit (104) pendant une durée prédéterminée ; et
la mesure du courant circulant du fait de la seconde partie pour déterminer l'impédance de boucle de terre de l'installation électrique (100).

2. Procédé selon la revendication 1, dans lequel le dispositif de protection de circuit (104) est un dispositif à courant résiduel.

3. Procédé selon la revendication 2, dans lequel le dispositif à courant résiduel est un dispositif à courant résiduel numérique mis en oeuvre au moyen d'un microprocesseur ou d'un processeur de signal numérique.

4. Procédé selon l'une quelconque des revendications précédentes, dans lequel ladite seconde partie de ladite séquence a une fréquence secteur normale de 50 Hz ou de 60 Hz.

5. Procédé selon l'une quelconque des revendications précédentes, dans lequel la fréquence de la première partie de la séquence est largement séparée de la seconde partie de la séquence pour permettre une facilité de différenciation.

6. Procédé selon l'une quelconque des revendications précédentes, dans lequel la première partie de la séquence n'est pas un harmonique de la fréquence secteur.

7. Procédé selon l'une quelconque des revendications précédentes, dans lequel l'amplitude de la première partie est réglée à un niveau inférieur à un niveau de déclenchement minimum du dispositif de protection de circuit.

8. Procédé selon l'une quelconque des revendications précédentes, comprenant en outre l'application d'une seconde partie de la séquence de plus grande amplitude pendant une durée inférieure à un temps de détection de déclenchement.

9. Procédé selon l'une quelconque des revendications précédentes, dans lequel après désactivation du fonctionnement du dispositif de protection de circuit (104) pendant une durée prédéterminée, le dispositif à courant résiduel revient à son mode de fonctionnement normal.

10. Procédé selon l'une quelconque des revendications précédentes, dans lequel la première partie couvre plusieurs cycles secteur, de sorte qu'un niveau de signal RMS global est inférieur au seuil de déclenchement du dispositif de protection de circuit.

11. Procédé selon l'une quelconque des revendications précédentes, dans lequel la séquence de signaux est modulée pour désactiver le fonctionnement du dispositif de protection de circuit (104).

12. Procédé selon la revendication 11, dans lequel la modulation comporte une modulation de temps, de fréquence, d'absence de modulation d'impulsion ou d'amplitude.

13. Procédé selon les revendications 11 ou 12, dans lequel la première partie est asservie en phase à la phase de tension de l'installation électrique (100) et appliquée au passage par zéro de la tension de phase.

14. Procédé selon la revendication 13, dans lequel la première partie de la séquence est émise plusieurs fois pour assurer la bonne réception de la séquence de signaux par le dispositif de protection de circuit (104).

15. Appareil permettant de déterminer l'impédance de boucle de terre d'une installation électrique (100) qui est protégée par un dispositif distant de protection de circuit (104), comprenant :
une source pour injecter une séquence de signaux dans un conducteur de l'installation électrique (100) à tester, la séquence de signaux comprenant une première partie pour désactiver le fonctionnement du dispositif distant de protection de circuit (104) pendant une durée prédéterminée et une seconde partie ayant une fréquence secteur normale de 50 Hz ou de 60 Hz pour surveiller l'impédance de boucle de terre de l'installation électrique (100) ; et
des moyens de mesure pour mesurer le courant circulant du fait de la seconde partie pour déterminer l'impédance de boucle de terre de l'installation électrique (100).

16. Appareil selon la revendication 15, dans lequel la source pour injecter une séquence de signaux dans un conducteur de l'installation électrique (100) à tester comprend :
une première source pour injecter la première partie de la séquence pour désactiver le fonctionnement du dispositif distant de protection de circuit (104) ; et
une seconde source pour injecter la seconde partie de la séquence pour surveiller l'impédance de boucle de terre de l'installation électrique (100).

17. Appareil selon la revendication 16, dans lequel la première source se trouve dans une unité auxiliaire distante située entre l'appareil et le dispositif distant de protection de circuit (104).

18. Appareil selon les revendications 15, 16 ou 17 dans lequel la séquence de signaux est une quelconque forme pouvant être produite par la source et détectée par le dispositif de protection de circuit (104).

19. Appareil selon les revendications 15 ou 18, dans lequel la séquence de signaux est unique, de sorte que le dispositif de protection de circuit (104) est désactivé seulement lorsqu'un test d'impédance de boucle de terre est sur le point d'être effectué.

20. Appareil selon l'une quelconque des revendications précédentes, dans lequel ladite seconde partie de ladite séquence a une fréquence secteur normale de 50 Hz ou de 60 Hz.

21. Dispositif de protection de circuit (104) permettant de détecter un courant résiduel dans une installation électrique (100), comprenant :
des moyens de détection pour détecter le courant résiduel dans l'installation électrique (100), le courant résiduel comprenant également une séquence de signaux générée par une source distante connectée à l'installation électrique (100), la séquence de signaux comprenant une première partie pour désactiver le fonctionnement du dispositif de protection de circuit (104) pendant une durée prédéterminée et une seconde partie qui, en service, détermine l'impédance de boucle de terre de l'installation électrique (100) par la source distante ;
des moyens de traitement, connectés aux moyens de détection, pour un traitement si la séquence de signaux comprend la première partie de la séquence et pour désactiver le fonctionnement du dispositif de protection de circuit (104) pendant une durée prédéterminée ; et
des moyens de relais, fonctionnant à partir des moyens de traitement, pour déconnecter l'alimentation électrique de l'installation électrique (100) si le courant résiduel dépasse un état de défaillance prédéterminé.

22. Dispositif de protection de circuit (104) selon la revendication 21, dans lequel le dispositif de protection de circuit (104) est un dispositif à courant résiduel.

23. Dispositif de protection de circuit (104) selon la revendication 22, dans lequel le dispositif à courant résiduel est un dispositif à courant résiduel numérique mis en oeuvre au moyen d'un microprocesseur ou d'un processeur de signal numérique.

24. Dispositif de protection de circuit (104) selon la revendication 22, dans lequel les moyens de détection comprennent en outre un tore à travers lequel passent la phase d'alimentation et le neutre et qui sert d'enroulement primaire d'un transformateur de courant et un enroulement secondaire autour du tore détecte le courant résiduel dans l'installation électrique (100).

25. Dispositif de protection de circuit (104) selon la revendication 24, dans lequel la sortie de l'enroulement secondaire est convertie en un signal numérique et filtrée ensuite pour être traitée par les moyens de traitement.

26. Dispositif de protection de circuit (104) selon les revendications 21 à 25, dans lequel la séquence de signaux générée par la source distante se trouve dans la largeur de bande des moyens de détection.

27. Dispositif de protection de circuit (104) selon l'une quelconque des revendications 21 à 26, dans lequel après désactivation du fonctionnement du dispositif de protection de circuit (104) pendant une durée prédéterminée, le dispositif à courant résiduel revient à son mode de fonctionnement normal.
